# EUROPEAN PATENT APPLICATION

(11) **EP 3 842 813 A1**
(43) Date of publication of application: **30.06.2021**
(21) Application number: 19219937.0
(22) Date of filing: 27.12.2019
(51) Int. Cl.: G01R 31/08, H02J 3/00, G01R 35/00, G01R 19/25, G01D 4/00

(54) **METHOD, DEVICE AND SYSTEM FOR THE AUTONOMOUS MAPPING OF AN ENERGY METER**

(30) Priority: 23.12.2019 PT 2019116015
(71) Applicant: Eneida Wireless & Sensors, S.A., 3030-199 Coimbra (PT)
(72) Inventor: GALHARDO, Bruno, 3030-199 Coimbra (PT); CERQUEIRA, Tiago, 3030-199 Coimbra (PT)
(74) Representative: do Nascimento Gomes, Rui

(57) **Abstract**

The present invention is enclosed in the area of intelligent monitoring and control of the grid topology of a power distribution network. It is an object of the present invention method for the autonomous mapping of an energy meter which comprises the following steps: i) obtaining at least one signal from a power transformer, ii) obtaining at least one signal from an energy meter, iii) correlating the at least one signal from the power transformer with the at least one signal from an energy meter, thereby obtaining a correlation value, and iv) based on the correlation value, determining if said energy meter is connected to a branch fed by said power transformer. The method of the present invention thereby provides the autonomous mapping of energy meters and, as a consequence, also of the household or other kind of installation which such energy meter monitors.

## Description

### FIELD OF THE INVENTION

The present invention is enclosed in the area of intelligent monitoring and control of the grid topology of a power distribution network.

### PRIOR ART

Today, the knowledge of the grid topology is reliant on the manual mapping of energy meters.

An installation/maintenance operator, with a specific device, injects a known pulse at the meter location, and the same signal is detected at one feeder/phase location at the transformer, thus giving its connection topology.

The main problem of these approaches is that they cannot keep up with several changes that occur in the network over time. Households can change feeder or phase without the knowledge of the operator, lines can be connected to other transformers without keeping track, among others. For blocks with no prior knowledge the operator needs to physically consult the device in question, and in some cases enter the household to do the mapping. Even still, such mapping methodology is not only cumbersome but also unreliable.

Some automatic solutions use only the energy (smart) meter data, as well as an assignment of a specific probable connection between such smart meter and a transformer and corresponding feeder.

Furthermore, even if correlations are performed between smart meters, there are limitations due to the number of accessible parameters. One can make correlations between the smart meters signals but this type of clustering is prone to be dependent of the model parameters and initial conditions.

Such is the case of the article of Seal, B.K., et al, "Automatic identification of service phase for electric utility customers", 2011 IEEE Power and Energy Society General Meeting.

Other approaches known in the art try to add additional variables such as GPS information of the meters. One of the problems is that this information is very sensitive and in some cases the operator is reluctant to provide. It is also prone to errors since the installers are responsible to log the coordinates and in some cases forget to add, or add several at some other location. Finally, it also makes assumptions on the topology and in the end households belonging to the same feeder can be uncorrelated to proximity.

Therefore, it becomes necessary to automatically map existing networks and periodically assert if there was a change in the known topology. It is therefore key to reliably know which substation (which has at least one associated transformer), corresponding feeder line and phase to which an energy smart meter is connected to, an improvement provided by the present invention.

### SUMMARY OF THE INVENTION

It is therefore an object of the present invention method for the autonomous mapping of an energy meter which comprises the following steps:
i) obtaining at least one signal from a power transformer,
ii) obtaining at least one signal from an energy meter,
iii) correlating the at least one signal from the power transformer with the at least one signal from an energy meter, thereby obtaining a correlation value, and
iv) based on the correlation value, determining if said energy meter is connected to a branch fed by said power transformer.

The method of the present invention thereby provides the autonomous mapping of energy meters and, as a consequence, also of the household or other kind of installation which such energy meter monitors. Such energy meters are commonly referred to as smart meters. The provision of one or more sensors in a transformer substation, which corresponds to the obtaining of at least one signal from such power transformer, allows to achieve an automated methodology, available to be implemented by a device which provides an indication of the branch to which the energy meter is connected.

Such solution therefore directly allows to, for a transformer substation, determine which installations - which may consist of households - are connected to which of its branches. It therefore provides the determination of the load in each branch, and a reliable determination and planning of the connections to the branches of the substation, which simply is not possible by the solutions known in the art.

It is also an object of the present invention a device for the autonomous mapping of an energy meter wherein it comprises computing means, said computing means being configured to implement the method of the present invention, in any of its embodiments. Such device may be provided locally, close to the transformer substation, or remotely, where it receives the signals from each energy meter and each transformer, corresponding feeder and/or corresponding phase.

Furthermore, it is an object of the present invention a system for the device for the autonomous mapping of an energy meter wherein it further comprises the device of the present invention and the referred energy meter, the energy meter being configured to remotely transmit said at least one signal to the device. Such system may further comprise a power transformer sensor configured to acquire said at least one signal from a power transformer, the power transformer sensor being configured to remotely transmit said at least one signal to the device. As referred, preferably the system comprises a plurality of power transformer sensors and energy meters. The referred remote transmission of signals to the device may be provided by means of a wireless communication protocol.

### DESCRIPTION OF FIGURES

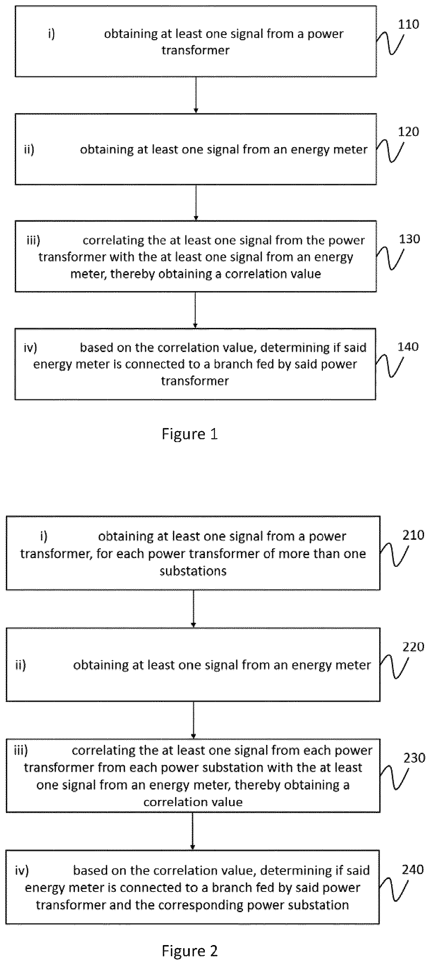

Figure 1 - representation of an embodiment of the method of the present invention, comprising the steps of i) obtaining at least one signal from a power transformer (110), ii) obtaining at least one signal from an energy meter (120), iii) correlating the at least one signal from the power transformer with the at least one signal from an energy meter, thereby obtaining a correlation value (130), and iv) based on the correlation value, determining if said energy meter is connected to a branch fed by said power transformer (140).
Figure 2 - representation of another embodiment of the method of the present invention, similar to the method of Figure 1 but in which it is expected that the energy meter may be connected to more than one power substation. Is such case, i) at least one signal from each power transformer of said more than one power substations (210), ii) at least one signal from an energy meter is obtained (220), iii) the at least one signal from each power transformer is correlated with the at least one signal from an energy meter, thereby obtaining a correlation value for each power transformer (230), and iv) based on the correlation values, determining if said energy meter is connected to a branch fed by said power transformer (240), and determining the respective power substation as well.

### DETAILED DESCRIPTION

The more general and advantageous configurations of the present invention are described in the Summary of the invention. Such configurations are detailed below in accordance with other advantageous and/or preferred embodiments of implementation of the present invention.

In an inventive aspect of the method of the present invention, the at least one signal from a power transformer is a signal obtained from a phase of such power transformer, wherein step iv) provides the determination of whether said energy meter is connected to a branch fed by said phase of the power transformer. It therefore provides a more detailed determination, by correlating with a phase of the power transformer.

In another inventive aspect of the method of the present invention, the at least one signal from a power transformer is a signal obtained from a feeder of said phase of the power transformer, wherein step iv) provides the determination of whether said energy meter is connected to a branch fed by said feeder of said phase of the power transformer. It therefore provides an even more detailed determination, by correlating with a feeder of the power transformer.

Specifically, the correlation of step iii) may comprise:
- determining a load of said transformer and assigning more than one energy meter to said load,
- summing the signals from said more than one energy meters, and
- the matching of said sum to the transformer load, wherein the correlation value is obtained from said matching.

It therefore allows to promptly identify the transformer and phase of branch to which the meter is connected from the signals of both such meter and transformer. Optionally, each signal from each energy meter comprises active power series data from such meter, which thereby allows to sum such values and obtain a result comparable (able to be matched) to the determined transformer load. Such procedure may be designated aggregation of meters. Preferably, said matching is performed at a monophasic level, and subsequently at a three-phasic level.

In another inventive aspect of the method of the present invention, said correlation of step iii) specifically comprises a correlation between three signals corresponding to each phase and the at least one signal from an energy meter, step iv) providing the determination of whether said energy meter is connected to a branch fed by said phase of the power transformer.

Specifically, the method of the present invention may further comprise, upon the determination of the branch fed a phase of the power transformer to which an energy meter is connected and upon determination that an energy meter has a null active power series data:
- matching such energy meter with at least one other energy meter which was determined to be connected in a same branch fed a phase of the power transformer, and
- correlating the at least one signal from the energy meter with the at least one signal from the other energy meter, obtaining the correlation value, and
thereby determining the correlation value, of whether said energy meter is connected to the same branch fed by said feeder of said phase of the power transformer, to which the other energy meter was determined to be connected.

It therefore allows to determine the branch to which a meter is connected even in the case that the referred active power series data is null.

In a preferred embodiment of the method of the present invention, it is implemented with a plurality of energy meters, the determination of the branch being implemented for each of such energy meters. For a case of a specific energy meter, the correlation the at least one signal from such energy meter is made with a plurality of signals from a plurality of other energy meters, and the correlation value is obtained from the other energy meter providing the highest correlation with the at least one signal from the energy meter.

Preferably, said at least one signal from a power transformer and said at least one signal from an energy meter consist of voltage signals.

Preferably, the sampling frequency of each of said signals is within the range of 3-20 minutes, preferably 5-15, more preferably 5 minutes.

In a particular embodiment of the method of the present invention, where it is expected that an energy meter may be connected to more than one power substation, the correlation is performed between such energy meter and information from such more than one power substation (which may contain more than one power transformer, each providing said at least one signal from a power transformer). Thus, the correlation of the method of the present invention is performed between each energy meter and each power transformer (or respective components), which may relate to different substations. In such case, the substation to which the energy meter is connected, and which corresponds to such determined power transformer, is also determined. Such is the case of the method of Figure 2.

A specific embodiment of the method of the present invention is described subsequently.

The method comprises two sequential steps.

The first is to identify the transformer and phase of the meter from the voltage signals of both a meter and a sensor at the transformer level. An individual voltage signal of the meter is compared to three signals measured by the referred sensor at the transformer level, and a match is found for the highest correlation between the comparisons (three, in the case of one transformer, 3n for n transformers). Smart energy meters tested had a sampling frequency of 15 minutes and transformer measurements had samplings of 5 minutes and 15 minutes. In both cases high accuracies were achieved.

A second step includes matching the energy meter to the feeder using measurements taken at feeder level. In such case, a classification with a branch is attempted to energy meters to which a transformer and phase were assigned from the previous step. From the several implemented tests, less than 1 % of the energy meters fail the previous step, usually due to some problem at the meter.

In such case, active power series of the meter and the transformer individual feeders are compared and an iterative process starts to assign and sum the individual meters to match the transformer load. This is done at a monophasic level, then a tri-phasic level. In the end the remaining meters (even those with zero active power) are matched with other meters of the same phase and the ones with highest correlation are assigned the same feeder.

The method of the present invention may implement known correlation methodologies known in the art. In a particular implementation, correlation coefficients are calculated between voltage signal series and between power series obtained from each energy meter. A measure of the correlation may be provided by a determination that higher these coefficients, the greater the similarity between the signals, and thereby the better the determination of the correlation.

In particular, the method of the present invention may provide enhanced results where, for phase mapping, voltage series of each phase of each smart meter is correlated with phases of each transformer, such transformer(s) preferably consisting of transformer(s) to which a connection is expected.

In particular, the method of the present invention may provide enhanced results where, for feeder mapping, active power series of each smart meter is correlated with the different transformer series (identified those obtained during phase mapping) of active power per feeder / phase.

Preferably, voltage and active power of smart meters is acquired by the smart meter itself and made available to the method and system of the present invention automatically or by an operator intervention.

In addition, voltage at transformer level may be provided by the transformer itself or by an external sensor. Active power may be provided by an external sensor, measured at each feeder / phase individually, as the transformer itself measures only one aggregation across all lines / phase.

As will be clear to one skilled in the art, the present invention should not be limited to the embodiments described herein, and a number of changes are possible which remain within the scope of the present invention.

Of course, the preferred embodiments shown above are combinable, in the different possible forms, being herein avoided the repetition all such combinations.

## Claims

1. A method for the autonomous mapping of an energy meter **characterised in that** it comprises the following steps:
i) obtaining at least one signal from a power transformer,
ii) obtaining at least one signal from an energy meter,
iii) correlating the at least one signal from the power transformer with the at least one signal from an energy meter, thereby obtaining a correlation value,
iv) based on the correlation value, determining if said energy meter is connected to a branch fed by said power transformer.

2. A method according to the previous claim wherein the at least one signal from a power transformer is a signal obtained from a phase of such power transformer, wherein step iv) provides the determination of whether said energy meter is connected to a branch fed by said phase of the power transformer.

3. A method according to the previous claim wherein the at least one signal from a power transformer is a signal obtained from a feeder of said phase of the power transformer, wherein step iv) provides the determination of whether said energy meter is connected to a branch fed by said feeder of said phase of the power transformer.

4. A method according to the previous claim wherein the correlation of step iii) specifically comprises:
- determining a load of said transformer and assigning more than one energy meter to said load,
- summing the signals from said more than one energy meters, and
- matching said sum to the transformer load, wherein the correlation value is obtained from said matching.

5. A method according to the previous claim wherein each signal from each energy meter comprises active power series data from such meter.

6. A method according to any of the claims 4-5 wherein said matching is performed at a monophasic level, and subsequently at a three-phasic level.

7. A method according to any of the preceding claims wherein said correlation of step iii) specifically comprises a correlation between three signals corresponding to each phase and the at least one signal from an energy meter, step iv) providing the determination of whether said energy meter is connected to a branch fed by said phase of the power transformer.

8. A method according to any of the claims 5-6 and claim 7 wherein it further comprises, upon the determination of the branch fed a phase of the power transformer to which an energy meter is connected and upon determination that an energy meter has a null active power series data:
- matching such energy meter with at least one other energy meter which was determined to be connected in a same branch fed a phase of the power transformer, and
- correlating the at least one signal from the energy meter with the at least one signal from the other energy meter, obtaining the correlation value, and
thereby determining the correlation value, of whether said energy meter is connected to the same branch fed by said feeder of said phase of the power transformer, to which the other energy meter was determined to be connected.

9. A method according to the previous claim wherein the correlation the at least one signal from the energy meter is made with a plurality of signals from a plurality of other energy meters, and the correlation value is obtained from the other energy meter providing the highest correlation with the at least one signal from the energy meter.

10. A method according to any of the preceding claims wherein said at least one signal from a power transformer and said at least one signal from an energy meter consist of voltage signals.

11. A method according to any of the preceding claims wherein the sampling frequency of each of said signals is within the range of 3-20 minutes, preferably 5-15, more preferably 15 minutes.

12. A device for the autonomous mapping of an energy meter wherein it comprises computing means, said computing means being configured to implement the method of any of the claims 1-10.

13. A system for the device for the autonomous mapping of an energy meter wherein it further comprises the device according to the previous claim and the referred energy meter, the energy meter being configured to remotely transmit said at least one signal to the device.

14. A system according to the previous claim wherein it further comprises a power transformer sensor configured to acquire said at least one signal from a power transformer, the power transformer sensor being configured to remotely transmit said at least one signal to the device.

15. A system according to the previous claim wherein the system comprises a plurality of power transformer sensors and energy meters.
